# EUROPEAN PATENT SPECIFICATION

(11) **EP 1 973 171 B1**
(45) Date of publication and mention of the grant of the patent: **27.02.2019**
(21) Application number: 08250930.8
(22) Date of filing: 18.03.2008
(51) Int. Cl.: H01L 31/048

(54) **Solar cell module**
Solarzellenmodul
Module de cellule solaire

(30) Priority: 20.03.2007 JP 2007073550
(43) Date of publication of application: 24.09.2008
(73) Proprietor: Panasonic Intellectual Property Management Co., Ltd., Osaka-shi, Osaka 540-6207 (JP)
(72) Inventor: Nakatani, Shihomi c/o Sanyo Electric Co., Ltd., Moriguchi City Osaka 570-8677 (JP); Kadonaga, Yasuo c/o Sanyo Electric Co., Ltd., Moriguchi City Osaka 570-8677 (JP); Ishii, Yousuke c/o Sanyo Electric Co., Ltd., Moriguchi City Osaka 570-8677 (JP); Hikosaka, Masaru c/o Sanyo Electric Co., Ltd., Moriguchi City Osaka 570-8677 (JP); Okamoto, Shingo c/o Sanyo Electric Co., Ltd., Moriguchi City Osaka 570-8677 (JP)
(74) Representative: Mewburn Ellis LLP

(56) References cited:
- EP-A1- 1 172 864
- JP-A- 59 072 183
- JP-A- H07 122 770
- JP-A- 2002 270 880
- JP-A- 2003 142 720
- US-A- 4 104 083

## Description

The present invention relates to a semiconductor device that responds to an infrared ray, visible light and a short electromagnetic wave, and particularly, to a solar cell module that converts radiation energy thereof into electric energy.

A solar cell can directly convert the sunbeam, which is a clean and unlimited energy source, into electricity, and accordingly, has attracted attention as a new energy source that is environment-friendly.

In the case of using such a solar cell as a power source (the energy source), it is common to use the solar cell in a form of a solar cell module of which output is enhanced by serially or parallely connecting a plurality of solar cells. The solar cell module is formed by electrically connecting connection electrodes of the plurality of solar cells to one another by a wiring member made of a conductive material such as copper foil, and by sealing the plurality of solar cells by a transparent sealing member such as ethylene vinyl acetate (EVA) between a transparent front surface protective member such as glass or transparent plastics and a back surface protective member made of a film of polyethylene terephthalate (PET) or the like.

The wiring member is arranged on one main surface of the solar cell. Therefore, it is desired to ensure electrical insulation between the wiring member and the front surface protective member and between the wiring member and the back surface protective member. For this, a technique to arrange two or more sealing members different in type between one surface protective member and the solar cell has been known (Japanese Patent Laid-Open No. 2006-278740). In this technique, by arranging a first sealing member on the one surface protective member side and arranging a second sealing member of which a softening point is lower than a softening point of the first sealing member on the solar cells side, the distance between the wiring member and the one surface protective member can be maintained more than the thickness of the first sealing member. Accordingly, the electrical insulation between the wiring member and the one surface protective member can be ensured.

When two or more sealing members different in type are used, the two or more sealing members different in type are sometimes exposed to a side surface of the solar cell module. Here, moisture is more prone to enter the solar cell module from an interface between the different types of sealing members than from an interface between same types of sealing members. Hence, in the case where the different types of sealing members are used, adhesion properties between the solar cells and the sealing members may be decreased due to entering of the moisture from the interface between the different types of sealing members exposed to the side surface of the solar cell module. Consequently, it is apprehended that moisture-resistant properties of the solar cell module may be decreased.

Other solar cell modules in which a plurality of solar cells are sealed by a sealing member including at least a first sealing member and a second sealing member are known in the art, e.g. from EP1172864 A1, JP59072183 A, US4104083 A, JP2003142720 A, JP2002270880 A and US5530264 A.

The present invention has been made in order to solve the above-described problem. It is an object of the present invention to enhance the moisuture-resistant properties of the solar cell module by reducing the entering of the moisture and the like from the side surface of the solar cell module. Further functions and effects obtained with the present invention are mentioned later in the description.

According to the present invention there is provided a solar cell module as specified in claim 1.
FIG. 1A is a cross-sectional view showing a configuration of a solar cell module according to a first example which is not part of the present invention.
FIG. 1B is a schematic view for explaining a method for manufacturing the solar cell module of FIG. 1A.
FIG. 2A is a cross-sectional view showing a configuration of a solar cell module according to a preferred embodiment of the present invention.
FIG. 2B is a schematic view for explaining a method for manufacturing the solar cell module of FIG. 2A.
FIG. 3A is a cross-sectional view showing a configuration of a solar cell module according to a second example which is not part of the present invention.
FIG. 3B is a schematic view for explaining a method for manufacturing the solar cell module of FIG. 3A.
FIG. 4A is a cross-sectional view showing a configuration of a solar cell module according to a third example which is not part of the present invention.
FIG. 4B is a schematic view for explaining a method for manufacturing the solar cell module of FIG. 4A.
FIG. 5A is a cross-sectional view showing a configuration of a solar cell module according to a fourth example which is not part of the present invention.
FIG. 5B is a schematic view for explaining a method for manufacturing the solar cell module of FIG. 5A.

A description will be made below of examples, which are not part of the present invention, and of the preferred embodiment of the present invention with reference to the drawings. In the description of the drawings, the same reference numerals are assigned to the same portions.

### (First Example which is not part of the present invention)

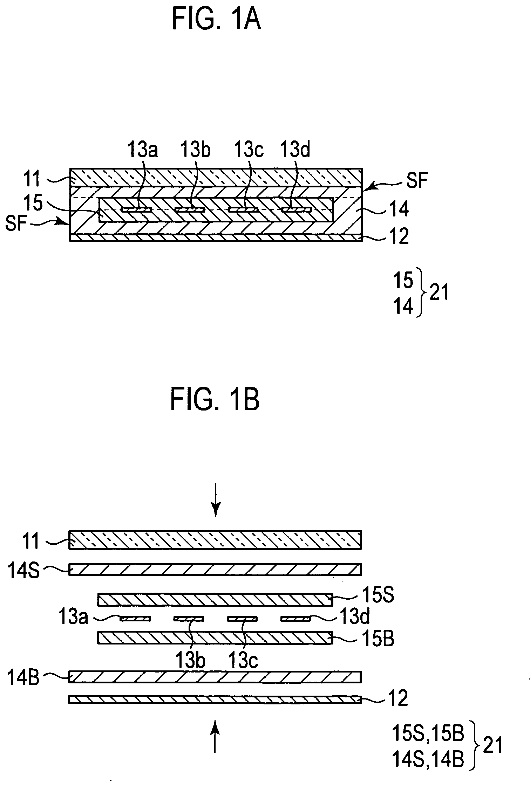

A description will be made of a configuration of a solar cell module according to a first example which is not part of the present invention with reference to FIG. 1A.

The solar cell module includes a plurality (for example, four) of solar cells 13a, 13b, 13c and 13d. Each of the solar cells 13a to 13d includes a photoelectric conversion part (not shown in FIG. 1A) that generates photogenerated carriers by light made incident thereonto, and a pair of positive and negative electrodes (not shown in FIG. 1A) for taking out the photogenerated carriers generated in the photoelectric conversion part. The plurality of solar cells 13a to 13d are electrically connected to one another in series or parallel, by connecting electrodes included in each of the solar cells each other by use of wiring member. Copper foil of which a surface is subjected to tin plating may be used as the wiring member. The plurality of solar cells 13a to 13d are sealed by a sealing member 21 between a front surface protective member 11 and a back surface protective member 12. Glass or transparent plastics may be used as the front surface protective member 11. A film of PET and the like, or a laminated material in which a thin metal film of Al and the like is sandwiched between films of the PET and the like may be used as the back surface protective member 12.

The sealing member 21 includes at least a first sealing member 14 and a second sealing member 15. The first sealing member 14 and the second sealing member 15 are different in type. Specifically, as the sealing member 21, two or more sealing members different in type are used.

Here, the sealing members different in type refer to sealing members in which at least principal chains are different. Moreover, to a side surface SF of the solar cell module, the front surface protective member 11, the sealing member 21 and the back surface protective member 12 are exposed. Among sealing members included in the sealing member 21, a sealing member exposed to the side surface SF of the solar cell module is the first sealing member 14. One or more sealing members other than the first sealing member 14 among the sealing members included in the sealing member 21, for example the the second sealing member 15 and the like, are not exposed to the side surface SF of the solar cell module. Specifically, the sealing member exposed to the side surface SF of the solar cell module is only one type of the sealing member. Note that the side surface SF of the solar cell module is shown as a surface exposed to the outside.

The first sealing member 14 and the second sealing member 15 are laminated at least either between the front surface protective member 11 and the solar cells 13a to 13d or between the solar cells 13a to 13d and the back surface protective member 12. In the first embodiment, a description will be made of the case where the first sealing member 14 and the second sealing member 15 are laminated both between the front surface protective member 11 and the solar cells 13a to 13d and between the solar cells 13a to 13d and the back surface protective member 12. In particular, one layer of the first sealing member 14 and one layer of the second sealing member 15 are laminated between the front surface protective member 11 and the solar cells 13a to 13d, in the first embodiment. Between the front surface protective member 11 and the solar cells 13a to 13d, the first sealing member 14 is disposed on the front surface protective member 11 side, and the second sealing member 15 is disposed on the solar cells 13a to 13d side. In a similar way, one layer of the second sealing member 15 and one layer of the first sealing member 14 are laminated between the solar cells 13a to 13d and the back surface protective member 12, in the first embodiment. Between the solar cells 13a to 13d and the back surface protective member 12, the second sealing member 15 is disposed on the solar cells 13a to 13d side, and the first sealing member 14 is disposed on the back surface protective member 12 side. Note that at least one layer of the first sealing member 14 and at least one layer of the second sealing member 15 just need to be laminated, and two or more layers of the first sealing member 14 or the second sealing member 15 may be laminated. For example, the second sealing member 15, the first sealing member 14 and the second sealing member 15 may be laminated in this order between the front surface protective member 11 and the solar cells 13a to 13d.

A material that composes the second sealing member 15 is different from a material that composes the first sealing member 14. Moreover, the second sealing member 15 contacts at least either main surfaces (first main surfaces) of the solar cells 13a to 13d on the front surface protective member 11 side or main surfaces (second main surfaces) of the solar cells 13a to 13d on the back surface protective member 12 side. In the first embodiment, a description will be made of the case where the second sealing member 15 contacts both of the first main surfaces and second main surfaces of the solar cells 13a to 13d. Moreover, the second sealing member 15 also contacts side surfaces of the solar cells 13a to 13d. Note that each of the side surfaces of the solar cells 13a to 13d contacts the first main surfaces and the second main surfaces. The second sealing member 15 is disposed so as to surround each of the solar cells 13a to 13d. Hence, there is no portion where the first sealing member 14 and the solar cells 13a to 13d contact each other. Furthermore, the second sealing member 15 is also disposed in gaps among the solar cells 13a to 13d adjacent to one another, and the one second sealing member 15 surrounds the entirety of the plurality of solar cells 13a to 13d.

The first sealing member 14 contacts at least either the front surface protective member 11 or the back surface protective member 12. Moreover, on a plane view of the solar cell module, the second sealing member 15 is disposed in a region including the solar cells 13a to 13d, and has an area smaller than the front surface protective member 11 and the back surface protective member 12 have. Moreover, the first sealing member 14 is also disposed in a region that is located on the same plane as the second sealing member 15 and surrounds the second sealing member 15. Hence, the second sealing member 15 that surrounds the solar cells 13a to 13d is embedded in the first sealing member 14, and the front surface protective member 11 and the back surface protective member 12 are adhered onto each other by the first sealing member 14. As the first sealing member 14, it is preferable to use an ethylene vinyl acetate copolymer (EVA) excellent in adhesion properties with the glass and a resin film.

In the first example which is not part of the present invention, a description will be made of the case where a sealing member, among sealing members included in the sealing member 21, that contacts the front surface protective member 11 and the back surface protective member 12 is the first sealing member 14, and the second sealing member 15 does not contact either the front surface protective member 11 or the back surface protective member 12. As the sealing member (the second sealing member 15) different in type from the EVA (the first sealing member 14), silicon resin, polyvinyl chloride, polyvinyl butyral (PVB), polyurethane, and the like are mentioned. These materials are composed so as to have different polymer, or are composed so as to have principal chains, side chains, functional groups, which are partially different from each other, and the like. Features of the respective materials are as follows. The silicon resin is a little inferior in weatherability to the other materials. The polyvinyl chloride is more prone to be affected by temperature and has larger elasticity than the other materials. Although the PVB is superior in ultraviolet resistance to the other materials, the PVB is inferior in shrinkage properties and water resistance. Although the polyurethane is superior in weatherability to the other materials, the polyurethane has larger elasticity.

A description will be made of a method for manufacturing the solar cell module of FIG. 1A with reference to FIG. 1B.
(A) First, a laminated body is formed by laminating a first sealing member 14S, a second sealing member 15S, the plurality of solar cells 13a to 13d connected to one another by the wiring member, a second sealing member 15B, a first sealing member 14B and the back surface protective member 12 on the front surface protective member 11 sequentially. As the front surface protective member 11, glass or transparent plastics is used. As the first sealing member 14S and the first sealing member 14B, the sheet-like EVA are used. As the second sealing member 15S and the second sealing member 15B, the sheet-like PVB are used. As the back surface protective member 12, the film of the PET and the like are used. At this time, on a plane view of the solar cell module, outer circumferences of the second sealing members 15S and 15B are located inside of outer circumferences of the first sealing members 14S and 14B. Moreover, the first main surfaces and the second main surfaces of the plurality of solar cells 13a to 13d are sandwiched between the second sealing members 15S and 15B. Moreover, on a plane view of the solar cell module, the plurality of solar cells 13a to 13d are located inside of the outer circumferences of the second sealing members 15S and 15B. An outer dimension of the front surface protective member 11 and the back surface protective member 12 is substantially equal to an outer dimension of the first sealing members 14S and 14B. Note that, as the back surface protective member 12, one having a three-layer structure of the PET, aluminum foil and the PET may be used.
(B) Then, the laminated body is disposed in a decompression chamber, and the decompression chamber is evacuated. Thereafter, the laminated body is heated and pressed at 150°C for 10 minutes, whereby the front surface protective member 11, the first sealing member 14S, the second sealing member 15S, the plurality of solar cells 13a to 13d, the second sealing member 15B, the first sealing member 14B and the back surface protective member 12 included in the laminated body are temporarily adhered with each other. Thereafter, the laminated body is heated at 150°C for one hour, whereby the sealing member 21, which is including the first sealing member 14S, the second sealing member 15S, the second sealing member 15B and the first sealing member 14B, is completely crosslinked. By the above-described steps, the solar cell module shown in FIG. 1A is completed. Thereafter, a terminal box and a metal frame may be attached onto the solar cell module according to needs.

In accordance with the first example which is not part of the present invention, which is as described above, the following functions and effects are obtained.

When the two or more sealing members different in type (the first sealing member 14 and the second sealing member 15) are used as the sealing member 21 that seals the solar cells 13a to 13d between the transparent front surface protective member 11 and the back surface protective member 12, the interface between the different types of sealing members are sometimes exposed to the side surface SF of the solar cell module. Here, moisture is more prone to enter the solar cell module from an interface between the different types of sealing members than from an interface between same types of sealing members. Hence, in the case where the interface between the different types of sealing members are exposed to the side surface SF of the solar cell module, adhesion properties between the solar cells 13a to 13d and the sealing members (the first sealing member 14 and the second sealing member 15) may be decreased due to entering of the moisture from the interface between the different types of sealing members exposed to the side surface of the solar cell module. Consequently, it is apprehended that moisture-resistant properties of the solar cell module may be decreased.

In this connection, when the two or more sealing members (the first sealing member 14 and the second sealing member 15) different in type are used as the sealing member 21, one (the first sealing member 14) of the sealing members is adapted to be exposed to the side surface SF of the solar cell module, in the first embodiment of the present invention. In such a way, the interface between the different types of sealing members is avoided being exposed to the side surface SF of the solar cell module. Accordingly, the entering of the moisture from the interface between the different types of sealing members is reduced, and the adhesion properties between the solar cells 13a to 13d and the sealing members (the first sealing member 14 and the second sealing member 15) is enhanced. Consequently, the and the moisture-resistant properties of the solar cell module is enhanced.

Moreover, the first sealing member 14 and the second sealing member 15 are laminated at least either between the front surface protective member 11 and the solar cells 13a to 13d or between the solar cells 13a to 13d and the back surface protective member 12. At this time, the first sealing member 14 is arranged on the one surface protective member side (the front surface protective member 11 side or the back surface protective member 12 side), and the second sealing member 15 is arranged on the solar cells 13a to 13d side. Here, the softening point of the first sealing member 14 and the softening point of the second sealing member 15 are differentiated by differentiating materials composing the first sealing member 14 and the second sealing member 15 respectively.

For example, a Vicat softening temperature of the EVA, which may be used as the first sealing member 14, is 70 to 120°C. On the other hand, a Vicat softening temperature of the PVB, which may be used as the second sealing member 15, is approximately 40°C.

That is to say, the softening point of the second sealing member 15 is lower than the softening point of the first sealing member 14. Hence, the distance between the wiring member and the one surface protective member (the front surface protective member 11 or the back surface protective member 12) can be maintained more than the thickness of the first sealing member 14, because the thickness of the first sealing member 14 is unchanged. Accordingly, the electrical insulation between the wiring member and the front surface protective member or the back surface protective member can be ensured. Furthermore, when the laminated body is heated and pressed, it is possible to avoid concentration of the pressure on the wiring member and to average the pressure added to each part of the solar cells 13a to 13d, because the second sealing member 15 which has lower softening point is arranged on the solar cells 13a to 13d side.

Moreover, for example, the first sealing member 14 made of the EVA and the second sealing member 15 made of the PVB excellent in ultraviolet resistance are laminated between the solar cells 13a to 13d and the front surface protective member 11, whereby a solar cell module excellent in ultraviolet resistance can be provided.

Among sealing members included in the sealing member 21, a sealing member that contacts the front surface protective member 11 and the back surface protective member 12 is the first sealing member 14. Moreover, the first sealing member 14 is composed of the ethylene vinyl acetate copolymer (EVA). Here, the ethylene vinyl acetate copolymer has strong adhesion force with the front surface protective member 11 and with the back surface protective member 12. Accordingly, the adhesion properties between the sealing member 21 and the front surface protective member 11 and the back surface protective member 12 are enhanced, and peeling becomes less likely to occur therebetween.

### (Preferred Embodiment)

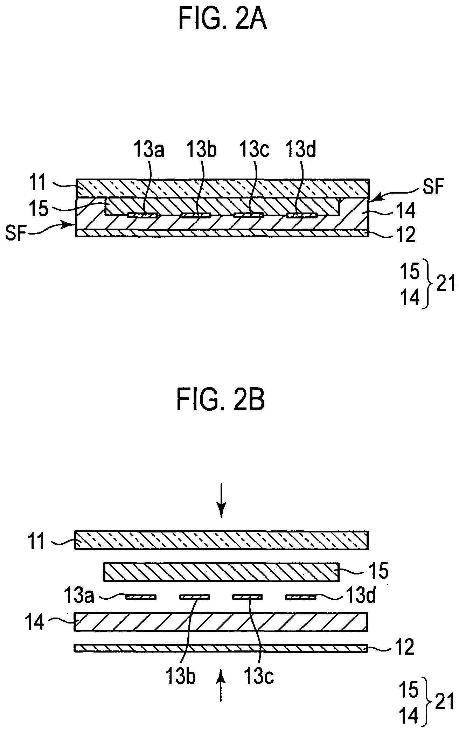

A description will be made of a configuration of a solar cell module according to a preferred embodiment of the present invention with reference to FIG. 2A.

In a similar way to the first example, the solar cell module according to the preferred embodiment includes the plurality of solar cells 13a, 13b, 13c and 13d connected in series or parallel by the wiring member, the transparent front surface protective member 11, the back surface protective member 12, and the transparent sealing member 21 that seals the plurality of solar cells 13a to 13d. In the second embodiment, the sealing member 21 includes the first sealing member 14 and the second sealing member 15. The first sealing member 14 and the second sealing member 15 are different in type. Specifically, as the sealing member 21, two or more sealing members different in type are used. Moreover, to a side surface SF of the solar cell module, the front surface protective member 11, the sealing member 21 and the back surface protective member 12 are exposed. Among sealing members included in the sealing member 21, a sealing member exposed to the side surface SF of the solar cell module is the first sealing member 14, and the second sealing member 15 is not exposed to the side surface SF of the solar cell module.

In the preferred embodiment, only the second sealing member 15 is disposed between the front surface protective member 11 and the solar cells 13a to 13d, and only the first sealing member 14 is disposed between the solar cells 13a to 13d and the back surface protective member 12. Specifically, though a piece of the sealing member 21 disposed between the front surface protective member 11 and the solar cells 13a to 13d and a piece of the sealing member 21 disposed between the solar cells 13a to 13d and the back surface protective member 12 are different in type from each other, each piece of the sealing member 21 has a single layer structure.

The second sealing member 15 contacts the first main surfaces of the solar cells 13a to 13d. The first sealing member 14 contacts the second main surfaces of the solar cells 13a to 13d. Both of the first sealing member 14 and the second sealing member 15 included in the sealing member 21 contact the front surface protective member 11. The first sealing member 14 contacts an outer circumferential portion of the front surface protective member 11, and the second sealing member 15 contacts a portion (a center portion) of the front surface protective member 11, which excludes the outer circumferential portion thereof. The first sealing member 14 contacts the back surface protective member 12, and the second sealing member 15 does not contact the back surface protective member 12.

Other configurations are the same as the solar cell module of FIG. 1A, and accordingly, a description thereof will be omitted.

A description will be made of a method for manufacturing the solar cell module of FIG. 2A with reference to FIG. 2B.
(A) First, a laminated body is formed by laminating a second sealing member 15, the plurality of solar cells 13a to 13d connected to one another by the wiring member, a first sealing member 14 and the back surface protective member 12 on the front surface protective member 11 sequentially. As the front surface protective member 11, glass or transparent plastics is used. As the second sealing member 15, the sheet-like PVB is used. As the first sealing member 14, the sheet-like EVA is used. As the back surface protective member 12, the film of the PET and the like are used. At this time, on a plane view of the solar cell module, outer circumferences of the second sealing member 15 are located inside of outer circumferences of the first sealing member 14. Moreover, on a plane view of the solar cell module, the plurality of solar cells 13a to 13d are located inside of the outer circumferences of the second sealing member 15. An outer dimension of the front surface protective member 11 and the back surface protective member 12 is substantially equal to an outer dimension of the first sealing member 14.
(B) Then, the laminated body is disposed in a decompression chamber, and the decompression chamber is evacuated. Thereafter, the laminated body is heated and pressed at 150°C for 10 minutes, whereby the front surface protective member 11, the second sealing member 15, the plurality of solar cells 13a to 13d, the first sealing member 14 and the back surface protective member 12 included in the laminated body are temporarily adhered with each other. Thereafter, the laminated body is heated at 150°C for one hour, whereby the sealing member 21, which is including the first sealing member 14 and the second sealing member 15, is completely crosslinked. By the above-described steps, the solar cell module shown in FIG. 2A is completed. Thereafter, a terminal box and a metal frame may be attached onto the solar cell module according to needs.

### Second Example which is not part of the present invention)

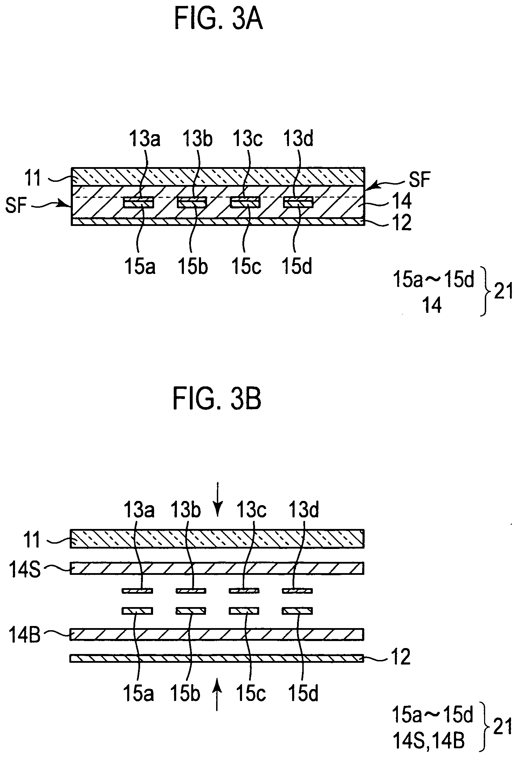

A description will be made of a configuration of a solar cell module according to a second example which is not part of the present invention with reference to FIG. 3A.

In a similar way to the first example, the solar cell module according to the second example includes the plurality of solar cells 13a, 13b, 13c and 13d connected in series or parallel by the wiring member, the transparent front surface protective member 11, the back surface protective member 12, and the transparent sealing member 21 that seals the plurality of solar cells 13a to 13d. In the third embodiment, the sealing member 21 includes the first sealing member 14 and the second sealing members 15a, 15b, 15c and 15d. The first sealing member 14 and the second sealing members 15a to 15d are different in type. Specifically, as the sealing member 21, two or more sealing members different in type are used. Moreover, to a side surface SF of the solar cell module, the front surface protective member 11, the sealing member 21 and the back surface protective member 12 are exposed. Among sealing members included in the sealing member 21, a sealing member exposed to the side surface SF of the solar cell module is the first sealing member 14, and the second sealing members 15a to 15d is not exposed to the side surface SF of the solar cell module.

In the second example, the first sealing member 14 and the second sealing members 15a to 15d are laminated between the solar cells 13a to 13d and the back surface protective member 12. Only the first sealing member 14 is disposed between the front surface protective member 11 and the solar cells 13a to 13d, and the first sealing member 14 forms a single layer structure.

The second sealing members 15a to 15d contact the second main surfaces of the solar cells 13a to 13d. Moreover, the second sealing members 15a to 15d are arranged separately from one another so as to correspond to the solar cells 13a to 13d, respectively. Hence, the first sealing member 14 is disposed in the gaps among the solar cells 13a to 13d adjacent to one another. The first sealing member 14 contacts the first main surfaces and side surfaces of the solar cells 13a to 13d. The first sealing member 14 contacts the front surface protective member 11 and the back surface protective member 12, and the second sealing member 15 does not contact either the front surface protective member 11 or the back surface protective member 12.

Other configurations are the same as the solar cell module of FIG. 1A, and accordingly, a description thereof will be omitted.

A description will be made of a method for manufacturing the solar cell module of FIG. 3A with reference to FIG. 3B.
(A) First, a laminated body is formed by laminating the first sealing member 14S, the plurality of solar cells 13a to 13d connected to one another by the wiring member, the second sealing members 15a to 15d, the first sealing member 14B and the back surface protective member 12 on the front surface protective member 11 sequentially. As the front surface protective member 11, glass or transparent plastics is used. As the first sealing member 14S and the first sealing member 14B, the sheet-like EVA are used. As the second sealing members 15a to 15d, the sheet-like PVB are used. As the back surface protective member 12, the film of the PET and the like are used. At this time, on a plane view of the solar cell module, outer circumferences of the second sealing members 15a to 15d are located inside of outer circumferences of the first sealing members 14S and 14B. Moreover, on a plane view of the solar cell module, an outer dimension of the plurality of solar cells 13a to 13d is substantially equal to an outer shape of the second sealing members 15a to 15d. The second sealing members 15a to 15d are arranged so as to be superposed on the solar cells 13a to 13d, respectively. An outer dimension of the front surface protective member 11 and the back surface protective member 12 is substantially equal to an outer dimension of the first sealing members 14S and 14B.
(B) Then, the laminated body is disposed in a decompression chamber, and the decompression chamber is evacuated. Thereafter, the laminated body is heated and pressed at 150°C for 10 minutes, whereby the front surface protective member 11, the first sealing member 14S, the plurality of solar cells 13a to 13d, the second sealing members 15a to 15d, the first sealing member 14B and the back surface protective member 12 included in the laminated body are temporarily adhered with each other. Thereafter, the laminated body is heated at 150°C for one hour, whereby the sealing member 21, which is including the first sealing member 14S, second sealing members 15a to 15d and the first sealing member 14B, is completely crosslinked. By the above-described steps, the solar cell module shown in FIG. 3A is completed. Thereafter, a terminal box and a metal frame may be attached onto the solar cell module according to needs.

### (Third Example which is not part of the present invention)

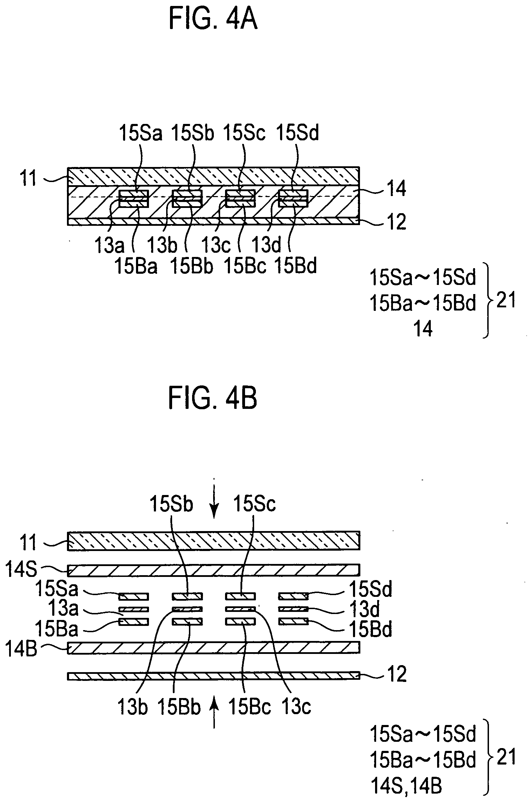

A description will be made of a configuration of a solar cell module according to a third example which is not part of the present invention with reference to FIG. 4A.

In a similar way to the first example, the solar cell module according to the third example includes the plurality of solar cells 13a, 13b, 13c and 13d connected in series or parallel by the wiring member, the transparent front surface protective member 11, the back surface protective member 12, and the transparent sealing member 21 that seals the plurality of solar cells 13a to 13d. In the third example, the sealing member 21 includes the first sealing member 14 and the second sealing members 15Sa, 15Sb, 15Sc and 15Sd, 15Ba, 15Bb, 15Bc and 15Bd. The first sealing member 14 and the second sealing members 15Sa to 15Sd and 15Ba to 15Bd are different in type. Specifically, as the sealing member 21, two or more sealing members different in type are used. Moreover, to a side surface SF of the solar cell module, the front surface protective member 11, the sealing member 21 and the back surface protective member 12 are exposed. Among sealing members included in the sealing member 21, a sealing member exposed to the side surface SF of the solar cell module is the first sealing member 14, and the second sealing members 15Sa to 15Sd and 15Ba to 15Bd are not exposed to the side surface SF of the solar cell module.

In the third example, the first sealing member 14 and the second sealing members 15Sa to 15Sd and 15Ba to 15Bd are laminated both between the front surface protective member 11 and the solar cells 13a to 13d and between the solar cells 13a to 13d and the back surface protective member 12. In particular, one layer of the first sealing member 14 and one layer of each of the second sealing members 15Sa to 15Sd are laminated between the front surface protective member 11 and the solar cells 13a to 13d. Between the front surface protective member 11 and the solar cells 13a to 13d, the first sealing member 14 is disposed on the front surface protective member 11 side, and the second sealing members 15Sa to 15Sd are arranged on the solar cells 13a to 13d side. In a similar way, one layer of each of the second sealing members 15Ba to 15Bd and one layer of the first sealing member 14 are laminated between the solar cells 13a to 13d and the back surface protective member 12. Between the solar cells 13a to 13d and the back surface protective member 12, the second sealing members 15Sa to 15Sd are arranged on the solar cells 13a to 13d side, and the first sealing member 14 is disposed on the back surface protective member 12 side. Note that, though a description is made of the case where one layer of the first sealing member 14, one layer of each of the second sealing members 15Sa to 15Sd and one layer of each of the second sealing members 15Ba to 15Bd are laminated between the front surface protective member 11 and the solar cells 13a to 13d and between the solar cells 13a to 13d and the back surface protective member 12, two or more layers of the first sealing member 14 or the second sealing member 15 may be laminated. For example, the second sealing member 15, the first sealing member 15 and the second sealing member 15 may be laminated in this order between the front surface protective member 11 and the solar cells 13a to 13d.

The second sealing members 15Sa to 15Sd contact the first main surfaces of the solar cells 13a to 13d, and the second sealing members 15Ba to 15Bd contact the second main surfaces of the solar cells 13a to 13d. Moreover, the second sealing members 15Sa to 15Sd and 15Ba to 15Bd are arranged separately from one another so as to correspond to the solar cells 13a to 13d, respectively. Hence, the first sealing member 14 is disposed in the gaps among the solar cells 13a to 13d adjacent to one another, and the first sealing member 14 contacts the side surfaces of the solar cells 13a to 13d. The first sealing member 14 contacts the front surface protective member 11 and the back surface protective member 12, and the second sealing member 15 does not contact either the front surface protective member 11 or the back surface protective member 12.

Other configurations are the same as the solar cell module of FIG. 1A, and accordingly, a description thereof will be omitted.

A description will be made of a method for manufacturing the solar cell module of FIG. 4A with reference to FIG. 4B.
(A) First, a laminated body is formed by laminating the first sealing member 14S, the second sealing members 15Sa to 15Sd, the plurality of solar cells 13a to 13d connected to one another by the wiring member, the second sealing members 15Ba to 15Bd, the first sealing member 14B and the back surface protective member 12 on the front surface protective member 11 sequentially. As the front surface protective member 11, glass or transparent plastics is used. As the first sealing member 14S and the first sealing member 14B, the sheet-like EVA are used. As the second sealing members 15Sa to 15Sd and the second sealing members 15Ba to 15Bd, the sheet-like PVB are used. As the back surface protective member 12, the film of the PET and the like are used. At this time, on a plane view of the solar cell module, outer circumferences of the second sealing members 15Sa to 15Sd and 15Ba to 15Bd are located inside of outer circumferences of the first sealing members 14S and 14B. Moreover, on a plane view of the solar cell module, an outer dimension of the plurality of solar cells 13a to 13d is substantially equal to an outer shape of the second sealing members 15Sa to 15Sd and 15Ba to 15Bd. The plurality of solar cells 13a to 13d are sandwiched between the second sealing members 15Sa to 15Sd and 15Ba to 15Bd, respectively, and the second sealing members 15Sa to 15Sd, the solar cells 13a to 13d and the second sealing members 15Ba to 15Bd are arranged so as to be superposed on one another, respectively. The outer dimension of the front surface protective member 11 and the back surface protective member 12 is substantially equal to the outer dimension of the first sealing members 14S and 14B.
(B) Then, the laminated body is disposed in a decompression chamber, and the decompression chamber is evacuated. Thereafter, the laminated body is heated and pressed at 150°C for 10 minutes, whereby the front surface protective member 11, the first sealing member 14S, the second sealing members 15Sa to 15Sd, the plurality of solar cells 13a to 13d, the second sealing members 15Ba to 15Bd, the first sealing member 14B and the back surface protective member 12 included in the laminated body are temporarily adhered with each other. Thereafter, the laminated body is heated at 150°C for one hour, whereby the sealing member 21, which is including the first sealing member 14S and 14B, and second sealing members 15Sa to 15Sd and 15Ba to 15Bd, is completely crosslinked. By the above-described steps, the solar cell module shown in FIG. 4A is completed. Thereafter, a terminal box and a metal frame may be attached onto the solar cell module according to needs.

### (Fourth Example which is not part of the present invention)

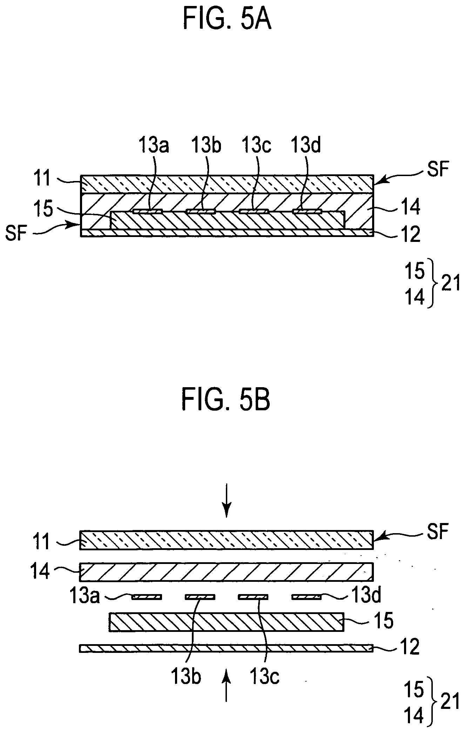

A description will be made of a configuration of a solar cell module according to a fourth example which is not part of the present invention with reference to FIG. 5A.

In a similar way to the first example, the solar cell module according to the fourth example includes the plurality of solar cells 13a, 13b, 13c and 13d connected in series or parallel by the wiring member, the transparent front surface protective member 11, the back surface protective member 12, and the transparent sealing member 21 that seals the plurality of solar cells 13a to 13d. In the fifth embodiment, the sealing member 21 includes the first sealing member 14 and the second sealing member 15. The first sealing member 14 and the second sealing member 15 are different in type. Specifically, as the sealing member 21, two or more sealing members different in type are used. Moreover, to a side surface SF of the solar cell module, the front surface protective member 11, the sealing member 21 and the back surface protective member 12 are exposed. Among sealing members included in the sealing member 21, a sealing member exposed to the side surface SF of the solar cell module is the first sealing member 14, and the second sealing members 15Sa to 15Sd and 15Ba to 15Bd are not exposed to the side surface SF of the solar cell module.

In the fourth example, only the first sealing member 14 is disposed between the front surface protective member 11 and the solar cells 13a to 13d, and only the second sealing member 15 is disposed between the solar cells 13a to 13d and the back surface protective member 12. Specifically, though a piece of the sealing member 21 disposed between the front surface protective member 11 and the solar cells 13a to 13d and a piece of the sealing member 21 disposed between the solar cells 13a to 13d and the back surface protective member 12 are different in type from each other, each piece of the sealing member 21 has a single layer structure.

The first sealing member 14 contacts the first main surfaces of the solar cells 13a to 13d. The second sealing member 15 contacts the second main surfaces of the solar cells 13a to 13d. Both of the first sealing member 14 and the second sealing member 15 included in the sealing member 21 contact the back surface protective member 12. The first sealing member 14 contacts an outer circumferential portion of the back surface protective member 12, and the second sealing member 15 contacts a portion (a center portion) of the back surface protective member 12, which excludes the outer circumferential portion thereof. The first sealing member 14 contacts the front surface protective member 11, and the second sealing member 15 does not contact the front surface protective member 11.

Other configurations are the same as the solar cell module of FIG. 1A, and accordingly, a description thereof will be omitted.

A description will be made of a method for manufacturing the solar cell module of FIG. 5A with reference to FIG. 5B.
(A) First, a laminated body is formed by laminating a first sealing member 14, the plurality of solar cells 13a to 13d connected to one another by the wiring member, a second sealing member 15 and the back surface protective member 12 on the front surface protective member 11 sequentially. As the front surface protective member 11, glass or transparent plastics is used. As the first sealing member 14, the sheet-like EVA is used. As the second sealing member 15, the sheet-like PVB is used. As the back surface protective member 12, the film of the PET and the like are used. At this time, on a plane view of the solar cell module, outer circumferences of the second sealing member 15 are located inside of outer circumferences of the first sealing member 14. Moreover, on a plane view of the solar cell module, the plurality of solar cells 13a to 13d are located inside of the outer circumferences of the second sealing member 15. An outer dimension of the front surface protective member 11 and the back surface protective member 12 is substantially equal to an outer dimension of the first sealing member 14.
(B) Then, the laminated body is disposed in a decompression chamber, and the decompression chamber is evacuated. Thereafter, the laminated body is heated and pressed at 150°C for 10 minutes, whereby the front surface protective member 11, the first sealing member 14, the plurality of solar cells 13a to 13d, the second sealing member 15 and the back surface protective member 12 included in the laminated body are temporarily adhered with each other. Thereafter, the laminated body is heated at 150°C for one hour, whereby the sealing member 21, which is including the first sealing member 14 and the second sealing member 15, is completely crosslinked. By the above-described steps, the solar cell module shown in FIG. 5A is completed. Thereafter, a terminal box and a metal frame may be attached onto the solar cell module according to needs.

### (Foreseen Modifications)

Although the description has been made of the case where the types of sealing members are two in the : preferred embodiment of the present invention as well as in the first to fourth examples which are not part of the invention, it is a matter of course that the types may be three or more. Although the description has been made of the case where the ethylene vinyl acetate copolymer (EVA) is used as the first sealing member 14, the present invention is not limited to this, and a sealing member different in type from the EVA, for example, silicon resin, polyvinyl chloride, PVB, polyurethane and the like may be used as the first sealing member 14. In this case, a sealing member different in type from the first sealing member 14 may be used as the second sealing member 15.

## Claims

1. A solar cell module in which a plurality of solar cells (13a-13d) are sealed by a sealing member (21) between a transparent front surface protective member (11) and a back surface protective member (12), wherein
the sealing member (21) includes at least a first sealing member (14) and a second sealing member (15),
the material of the second sealing member (15) is different from the material of the first sealing member (14), a softening point of the material of the second sealing member (15) is lower than the softening point of the material of the first sealing member (14);
the sealing member exposed to a side surface (SF) of the solar cell module is the first sealing member (14);
an interface between the first sealing member (14) and the second sealing member (15) is not exposed to the side surface (SF) of the solar cell module;
the first sealing member (14) is in direct contact with the back surfaces of the plurality of solar cells (13a-13d) and the back surface protective member (12);
the second sealing member (15) is in direct contact with the front surfaces of the plurality of solar cells (13a-13d) and the transparent front surface protective member (11); and
the first sealing member (14) and the second sealing member (15) are in direct contact with each other between the side surface (SF) of the solar cell module and a solar cell of the plurality of solar cells (13a-13d) that is located nearest to the side surface (SF) of the solar cell module, and between adjacent solar cells of the plurality of solar cells (13a-13d) .

2. The solar cell module according to claim 1, wherein the first sealing member (14) contacts an outer circumference of the front surface protective member (11) and an outer circumference of the back surface protective member (12).

3. The solar cell module according to any one of claims 1 and 2, wherein
the first sealing member (14) contacts the front surface protective member (11) and the back surface protective member (12), and
the first sealing member (14) is composed of an ethylene vinyl acetate copolymer (EVA).

4. The solar cell module according to any one of claims 1, 2 and 3, wherein:
the first sealing member (14) and the second sealing member (15) are sheet-like members, respectively;
on a plane view of the solar cell module, an outer circumference of the second sealing member (15) is located inside of an outer circumference of the first sealing member (14) ;
on a plane view of the solar cell module, the plurality of solar cells (13a-13d) are located inside of an outer circumference of the second sealing member (15).

## Patentansprüche

1. Solarzellenmodul, in dem eine Vielzahl an Solarzellen (13a-13d) durch ein Versiegelungselement (21) zwischen einem transparenten Vorderseitenoberflächenschutzelement (11) und einem Rückseiten-Oberflächenschutzelement (12) versiegelt sind, wobei
das Versiegelungselement (21) zumindest ein erstes Versiegelungselement (14) und ein zweites Versiegelungselement (15) umfasst,
das Material des zweiten Versiegelungselements (15) sich vom Material des ersten Versiegelungselements (14) unterscheidet,
ein Erweichungspunkt des Materials des zweiten Versiegelungselements (15) niedriger ist als der Erweichungspunkt des Materials des ersten Versiegelungselements (14);
das Versiegelungselement, das an einer Seitenfläche (SF) des Solarzellenmoduls frei liegt, das erste Versiegelungselement (14) ist;
eine Grenzfläche zwischen dem ersten Versiegelungselement (14) und dem zweiten Versiegelungselement (15) nicht auf der Seitenfläche (SF) des Solarzellenmoduls liegt;
das erste Versiegelungselement (14) in direktem Kontakt mit den Rückseiten-Oberflächen der Vielzahl an Solarzellen (13a-13d) und dem Rückseitenoberflächenschutzelement (12) steht;
das zweite Versiegelungselement (15) in direktem Kontakt mit den Vorderseitenoberflächen der Vielzahl an Solarzellen (13a-13d) und dem transparenten Vorderseitenoberflächenschutzelement (11) steht; und
das erste Versiegelungselement (14) und das zweite Versiegelungselement (15) in direktem Kontakt miteinander zwischen der Seitenfläche (SF) des Solarzellenmoduls und einer Solarzelle der Vielzahl an Solarzellen (13a-13d), die am nächsten zur Seitenfläche (SF) des Solarzellenmoduls liegt, und zwischen benachbarten Solarzellen der Vielzahl an Solarzellen (13a-13d) stehen.

2. Solarzellenmodul nach Anspruch 1, wobei das erste Versiegelungselement (14) mit einem Außenumfang des Vorderseitenoberflächenschutzelements (11) und einem Außenumfang des Rückseitenoberflächenschutzelements (12) in Kontakt ist.

3. Solarzellenmodul nach einem der Ansprüche 1 und 2,
wobei
das erste Versiegelungselement (14) mit dem Vorderseitenoberflächenschutzelement (11) und dem Rückseitenoberflächenschutzelement (12) in Kontakt ist, und
das erste Versiegelungselement (14) aus einem Ethylen-Vinylacetat-Copolymer (EVA) zusammengesetzt ist.

4. Solarzellenmodul nach einem der Ansprüche 1, 2 und 3, wobei:
das erste Versiegelungselement (14) bzw. das zweite Versiegelungselement (15) plattenförmige Elemente sind;
ein Außenumfang des zweiten Versiegelungselements (15) auf einer Draufsicht des Solarzellenmoduls innerhalb eines Außenumfangs des ersten Versiegelungselements (14) liegt;
die Vielzahl an Solarzellen (13a-13d) auf einer Draufsicht des Solarzellenmoduls innerhalb eines Außenumfangs des zweiten Versiegelungselements (15) liegt.

## Revendications

1. Module de cellules solaires dans lequel une pluralité de cellules solaires (13a-13d) sont rendues étanches par un élément d'étanchéité (21) entre un élément de protection de surface avant transparent (11) et un élément de protection de surface arrière (12), dans lequel
l'élément d'étanchéité (21) comprend au moins un premier élément d'étanchéité (14) et un second élément d'étanchéité (15),
le matériau du second élément d'étanchéité (15) est différent du matériau du premier élément d'étanchéité (14),
un point de ramollissement du matériau du second élément d'étanchéité (15) est inférieur au point de ramollissement du matériau du premier élément d'étanchéité (14) ;
l'élément d'étanchéité exposé à une surface latérale (SF) du module de cellules solaires est le premier élément d'étanchéité (14) ;
une interface entre le premier élément d'étanchéité (14) et le second élément d'étanchéité (15) n'est pas exposée à la surface latérale (SF) du module de cellules solaires ;
le premier élément d'étanchéité (14) est en contact direct avec les surfaces arrière de la pluralité de cellules solaires (13a-13d) et avec l'élément de protection de surface arrière (12) ;
le second élément d'étanchéité (15) est en contact direct avec les surfaces avant de la pluralité de cellules solaires (13a-13d) et avec l'élément de protection de surface avant transparent (11) ; et
le premier élément d'étanchéité (14) et le second élément d'étanchéité (15) sont en contact direct l'un avec l'autre entre la surface latérale (SF) du module de cellules solaires et une cellule solaire de la pluralité de cellules solaires (13a-13d) qui est située la plus proche de la surface latérale (SF) du module de cellules solaires, et entre des cellules solaires adjacentes de la pluralité de cellules solaires (13a-13d).

2. Module de cellules solaires selon la revendication 1, dans lequel le premier élément d'étanchéité (14) vient en contact avec une circonférence extérieure de l'élément de protection de surface avant (11) et une circonférence extérieure de l'élément de protection de surface arrière (12) .

3. Module de cellules solaires selon l'une quelconque des revendications 1 et 2, dans lequel
le premier élément d'étanchéité (14) vient en contact avec l'élément de protection de surface avant (11) et l'élément de protection de surface arrière (12), et
le premier élément d'étanchéité (14) est composé d'un copolymère d'éthylène et d'acétate de vinyle (EVA).

4. Module de cellules solaires selon l'une quelconque des revendications 1, 2 et 3, dans lequel :
le premier élément d'étanchéité (14) et le second élément d'étanchéité (15) sont des éléments analogues à une feuille, respectivement ;
sur une vue en plan du module de cellules solaires, une circonférence extérieure du second élément d'étanchéité (15) est située à l'intérieur d'une circonférence extérieure du premier élément d'étanchéité (14) ;
sur une vue en plan du module de cellules solaires, la pluralité de cellules solaires (13a-13d) sont situées à l'intérieur d'une circonférence extérieure du second élément d'étanchéité (15).
